# EUROPÄISCHE PATENTANMELDUNG

(11) **EP 2 445 005 A1**
(43) Veröffentlichungstag der Anmeldung: **25.04.2012**
(21) Anmeldenummer: 10188533.3
(22) Anmeldetag: 22.10.2010
(51) Int. Cl.: H01L 23/40

(54) **Kühlvorrichtung mit Flachfeder**

(71) Anmelder: SIEMENS AKTIENGESELLSCHAFT, 80333 München (DE)
(72) Erfinder: Rümpler, Hannes, 99085, Erfurt (DE)

(57) **Zusammenfassung**

Die Erfindung betrifft eine Kühlvorrichtung (1) umfassend
- einen Kühlkörper (2),
- eine Trägervorrichtung (3) mit einer Oberseite (3a) und einer Unterseite (3b),
- ein elektronisches Bauteil (4),
- eine Flachfeder (10),
wobei das elektronische Bauteil (4) auf der Oberseite (4a) angeordnet ist und der Kühlkörper (2) auf dem elektronischen Bauteil (4) aufliegt,
wobei die Flachfeder (10) an der Unterseite (3b) derart angeordnet ist, dass sie mit einem ersten Haltemittel (11a) und einem zweitem Haltemittel (12a) durch eine erste Ausnehmung (31) und eine zweite Ausnehmung (32) in der Trägervorrichtung (3) greift, wobei der Kühlkörper (2) ein erstes Verrastmittel (21) und ein zweites Verrastmittel (22) aufweist, in welche die Haltemittel (11a,12a) verrasten, wobei die Flachfeder (10) derart vorgeprägt ist, dass diese im gespannten Zustand eine Anpresskraft (F) zentrisch unter dem elektronischen Bauteil in die Trägervorrichtung (3) einleitet.

## Beschreibung

Die Erfindung betrifft eine Kühlvorrichtung, umfassend einen Kühlkörper, eine Trägervorrichtung mit einer Oberseite und einer Unterseite, ein elektronisches Bauteil, eine Flachfeder, wobei das elektronische Bauteil auf der Oberseite angeordnet ist und der Kühlkörper auf dem elektronischen Bauteil aufliegt.

Aus der Offenlegungsschrift US 2004/0207076 A1 ist eine Kühlvorrichtung mit einem Kühlkörper, einer Flachfeder und einer Trägervorrichtung bekannt. Der Kühlkörper der bekannten Vorrichtung wird mittels einer Flachfeder auf das elektronische Bauteil gepresst. Die Flachfeder wird dabei in die Trägervorrichtung eingelassene Ankerelemente eingehakt und dadurch ein Druck mittels der Flachfeder auf den Kühlkörper ausgeübt.

Aufgabe der vorliegenden Erfindung ist es, die bekannte Vorrichtung derart zu verbessern, dass eine Anpresskraft des Kühlkörpers auf das elektronische Bauteil optimiert wird und dadurch ein Wärmeübergang von dem elektronischen Bauteil auf den Kühlkörper verbessert wird.

Mit der Kühlvorrichtung nach dem Oberbegriff des Patentanspruchs 1 wird die Aufgabe dadurch gelöst, dass die Flachfeder an der Unterseite derart angeordnet ist, dass sie mit einem ersten Haltemittel und einem zweiten Haltemittel durch eine erste Ausnehmung und eine zweite Ausnehmung in der Trägervorrichtung greift, wobei der Kühlkörper ein erstes Verrastmittel und ein zweites Verrastmittel aufweist, in welche die Haltemittel verrasten, wobei die Flachfeder derart vorgeprägt ist, dass diese im gespannten Zustand eine Anpresskraft zentrisch unter dem elektronischen Bauteil in die Trägervorrichtung einleitet. Eine Anbindung des Kühlkörpers an das elektronische Bauteil erfolgt mittels der vorgeprägten Flachfeder, welche um die Trägervorrichtung bzw. durch die Trägervorrichtung greift und vorzugsweise direkt in dem Kühlkörper verrastet. In einem gespannten Zustand der Flachfeder liegt diese flach über der Oberfläche, also der Unterseite, der Trägervorrichtung und leitet die durch das Biegemoment der Flachfeder entstehende Anpresskraft zentrisch unter dem mit dem Kühlkörper zu kontaktierenden Bauteil in die Trägervorrichtung ein. Vorzugsweise ist die Trägervorrichtung dabei als eine Leiterplatte, insbesondere als eine Multilayer-Leiterplatte ausgestaltet. Auf dieser Leiterplatte sind sodann beispielsweise Mikroprozessoren, welche bei Betrieb eine erhöhte Wärmeabgabe aufweisen, angeordnet.

In einer vorteilhaften Ausgestaltung der Kühlvorrichtung ist die Flachfeder mit einem ersten Schenkel versehen, an welchem das erste Haltemittel angeordnet ist und mit einem zweiten Schenkel an welchem das zweite Haltemittel angeordnet ist. Die durch die Flachfeder erzeugte Anpresskraft kann somit bei der Auslegung der Flachfeder maximiert und nah an eine mechanische Belastungsgrenze des elektronischen Bauteils bzw. der Leiterplatte geführt werden. Die dadurch entstehende maximale Anpresskraft, ohne eine mechanische Überlastung hervorzurufen, gewährleistet einen minimalen thermischen Übergangswiderstand von dem elektronischen Bauteil auf den Kühlkörper und somit einen optimalen Wärmeübergang.

Eine weitere Optimierung der Krafteinleitung ergibt sich dadurch, dass auf einen Federkörper der Flachfeder zwischen dem ersten Haltemittel und dem zweiten Haltemittel eine punktuelle Erhebung zur Einleitung der Anpresskraft angeordnet ist. Da Kraft gleich Druck pro Fläche ist, wird durch diese konstruktive Maßnahme die einzuleitende Anpresskraft konzentriert, da die Fläche minimiert wurde.

In einer vorteilhaften Ausgestaltung ist die punktuelle Erhebung als eine Sicke ausgestaltet. Sicke ist dabei als eine Art Warze, vorzugsweise eine Beule, zu verstehen.

Auch ist es denkbar, die punktuelle Erhebung als ein Niet auszugestalten.

In einer vorteilhaften Ausgestaltung ist die punktuelle Erhebung in dem Federkörper der Flachfeder derart ausgestaltet, dass der Niet in der Sicke angeordnet ist.

Eine gute Kraftverteilung wird erreicht, wenn die Flachfeder einen dritten Schenkel, an welchem ein drittes Haltemittel angeordnet ist, aufweist.

Um eine spätere Montage der Kühlvorrichtung zu vereinfachen, ist die Flachfeder mit ihren drei Schenkeln vorzugsweise Y-förmig ausgestaltet. Die zentrische Krafteinleitung auf der Unterseite der Trägervorrichtung bildet eine pendelnde Lagerung, wodurch eventuelle Fertigungstoleranzen an der Flachfeder und dem Kühlkörper nur einfach wirken und sich in einer Toleranzkette nicht aufsummieren. Der Federweg selbst unterliegt somit nur geringen Schwankungen wodurch sich die Federkraft sehr genau einstellen lässt.

Um einen Wärmeübergang weiter zu verbessern, ist zwischen dem elektronischen Bauteil und dem Kühlkörper ein Wärmeleitmittel angeordnet.

Vorzugsweise sind in der Umgebung um das elektronische Bauteil ein oder mehrere Abstandshalter derart angeordnet, dass der Kühlkörper eine Kippgrenze nicht überschreiten kann. Da der Kühlkörper selbst in einer Ebene zu dem elektronischen Bauteil geführt sein sollte, sowie in geeigneter Weise gegen ein Verkippen gesichert werden sollte, haben sich Abstandshalter, insbesondere mechanische Anschläge, vorteilhafter Weise Dummy-Bauteile, als vorteilhaft herausgestellt.

Die Zeichnung zeigt ein Ausführungsbeispiel und weitere Ausgestaltungsmerkmale, dabei zeigt
- FIG 1: eine Kühlvorrichtung auf einer Flachbaugruppe,
- FIG 2: eine Flachfeder in einer Draufsicht und
- FIG 3: einen Schnitt aus der aus FIG 1 bekannten Flachfeder.

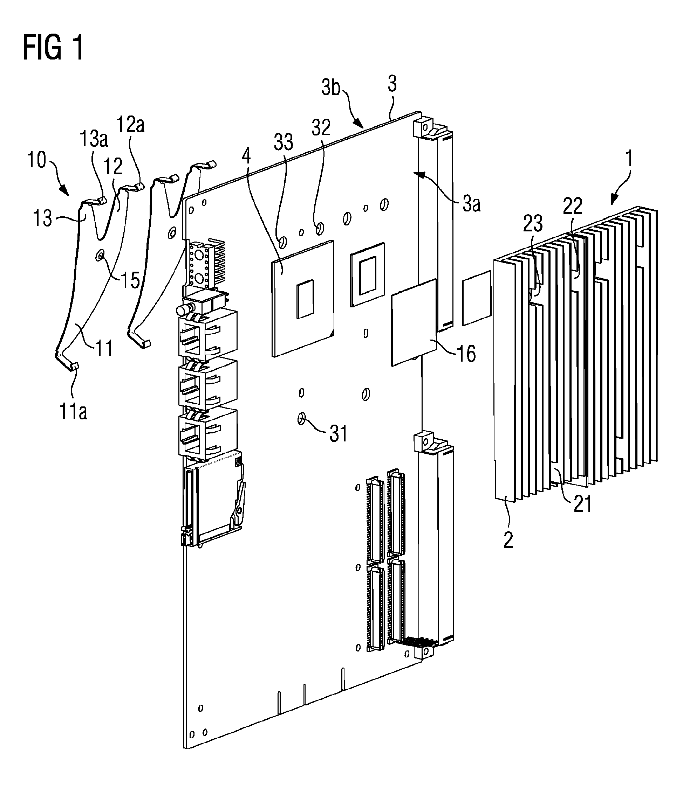

Gemäß FIG 1 ist eine Flachbaugruppe mit einer Kühlvorrichtung 1 dargestellt, wobei die Flachbaugruppe im Wesentlichen durch eine Trägervorrichtung 3 mit bestückten elektronischen Bauteilen gegeben ist. Die Trägervorrichtung 3 ist als eine elektronische Leiterplatte ausgestaltet. Die Kühlvorrichtung 1 umfasst einen Kühlkörper 2, die Leiterplatte mit einer Oberseite 3a und einer Unterseite 3b sowie das zu kühlende elektronische Bauteil 4 und eine Flachfeder 10. Das gemäß FIG 1 gewählte Ausführungsbeispiel weist eine zweite Flachfeder auf, wobei diese mit Bezugszeichen nicht weiter beziffert ist, da der konstruktive Zusammenhang offensichtlich ist. Auch ist der Kühlkörper 2 aus zwei Elementen ausgestaltet, welche durch die zwei genannten Flachfedern an die Leiterplatte bzw. die elektronischen Bauteile angepresst werden. Im weiteren Verlauf der Figurenbeschreibung wird aber nur auf einen Teil des Kühlkörpers 2 eingegangen.

Die Flachfeder 10 ist derart an der Unterseite 3b der Leiterplatte angeordnet, dass sie mit einem ersten Haltemittel 11a und einem zweiten Haltemittel 12a durch eine erste Ausnehmung 31 und eine zweite Ausnehmung 32 in der Leiterplatte greift, da die Flachfeder 10 Y-förmig ausgestaltet ist, greift auch ein drittes Haltemittel 13a durch eine dritte Ausnehmung 33 durch die Leiterplatte. Bei auf das elektronische Bauteil 4 aufgesetzten Kühlkörper 2 kann das erste Haltemittel 11a in ein erstes Verrastmittel 21, das zweite Haltemittel 12a in ein zweites Verrastmittel 22 und das dritte Haltemittel 13a in ein drittes Verrastmittel 23 verrasten. Die Flachfeder 10 ist dabei ausgestaltet, dass sie derart vorgeprägt ist, dass diese in einem gespannten Zustand, also in dem verrasteten Zustand, eine Anpresskraft F zentrisch unter dem elektronischen Bauteil 4 in die Leiterplatte, also in die Trägervorrichtung 3, einleitet.

Demnach erfolgt die Anbindung des Kühlkörpers 2 an das elektronische Bauteil 4 mittels der vorgeprägten Flachfeder 10, welche derart stellenweise durch die Leiterplatte durchgreift und direkt in den Kühlkörper verrastet, dass eine Anpresskraft des elektronischen Bauteils 4 auf den Kühlkörper 2 erzeugt wird. Im gespannten Zustand liegt die Flachfeder 10 flach über der Unterseite 3b und leitet mittels eines Nietes 15 die Anpresskraft F zentrisch unter dem zu kühlenden Bauteil 4 in die Leiterplatte ein. Durch die zentrische Krafteinleitung liegt der überwiegende Teil der Flachfeder 10 in einem definierten Abstand über der Unterseite 3b der Leiterplatte (Trägerstruktur 3), wodurch dieser Platz genutzt werden kann, um beispielsweise weitere elektrische Bauelemente auf der Unterseite 3b zu bestücken.

Zwischen dem Kühlkörper 2 und dem elektronischen Bauteil 4 ist ein Wärmeleitmittel 16 angeordnet. Dieses Wärmeleitmittel 16 wird als ein thermisches Interface verpresst. Um den Kühlkörper 2 in einer Ebene zu führen, sowie in geeigneter Weise gegen ein Verkippen zu sichern, sind in der Umgebung um das elektronische Bauteil 4 ein oder mehrere Abstandshalter derart angeordnet, dass der Kühlkörper 2 eine Kippgrenze nicht überschreiten kann.

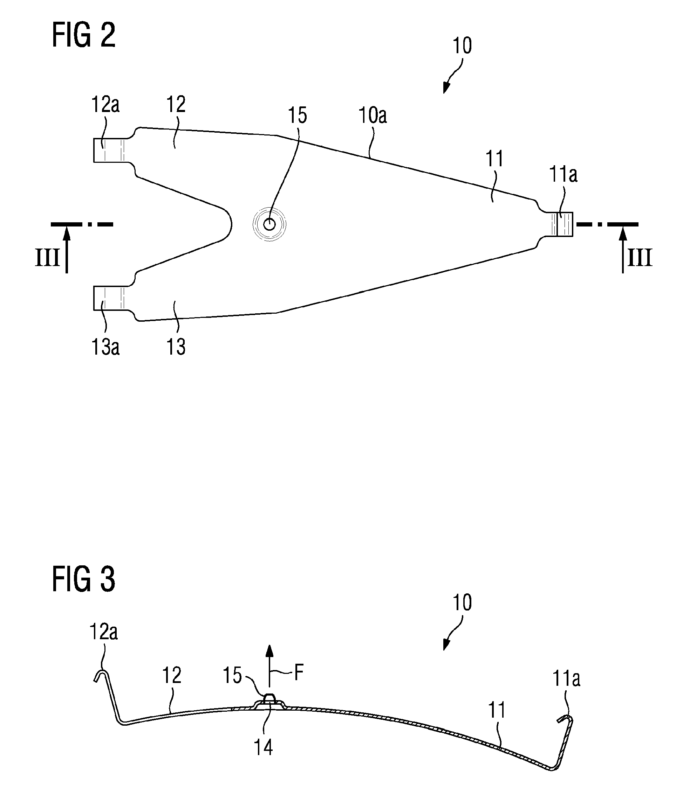

Die Flachfeder 10 ist in FIG 2 in einer Draufsicht dargestellt. Die Flachfeder 10 ist Y-förmig ausgestaltet und weist einen ersten Schenkel 11, an welchem ein erstes Haltemittel 11a angeordnet ist, einen zweiten Schenkel 12, an welchem ein zweites Haltemittel 12a angeordnet ist und einen dritten Schenkel 13, an welchem ein drittes Haltemittel 13a angeordnet ist, auf. Der überwiegende Teil der Flachfeder 10 wird durch einen Federkörper 10a gebildet. Im Inneren des Federkörpers 10a ist als eine punktuelle Erhebung ein Niet 15 angeordnet. Der Niet 15 bzw. die punktuelle Erhebung ist auf einer Symmetrieachse der Flachfeder 10 angeordnet. Durch ein Verschieben der Anordnung des Nietes 15 auf der Symmetrieachse lässt sich ein Punkt zur konzentrierten Einleitung einer Anpresskraft F einstellen. Weiterhin lässt sich durch verlängern oder verkürzen der Schenkel die Anpresskraft F einstellen.

FIG 3 zeigt den Schnitt III-III an der Schnittlinie III aus FIG 2. Ein Ende des ersten Schenkels 11 zeigt das erste Haltemittel 11a in einer seitlichen Darstellung, wobei das Haltemittel 11a als Haken ausgeführt ist, welcher sich in dem Verrastmittel des Kühlkörpers verhaken bzw. verrasten kann. Ein weiteres Ende des zweiten Schenkels 12 zeigt das zweite Haltemittel 12a, welches auch als ein Haken ausgestaltet ist. Dabei ist das erste Haltemittel 11a mit seinem Haken in Richtung des Nietes 15 gebogen und das zweite Haltemittel 12a mit seinem Haken in Richtung von dem Niet 15 weggebogen.

Die als Sicke 14 ausgestaltete punktuelle Erhebung ist in der Schnittdarstellung besonders deutlich zu sehen. In der Sicke 14 ist ein Niet 15 angeordnet. Der Niet ist vorzugsweise nach DIN 660-1.4x2 ausgestaltet und aus einem Kupferzinnmaterial gefertigt und dient darüber hinaus als ein elektrischer Kontakt zur Schirmung des Bauteils um beispielsweise EMV-Störeinflüsse zu minimieren.

## Patentansprüche

1. Kühlvorrichtung (1), umfassend
- einen Kühlkörper (2),
- eine Trägervorrichtung (3) mit einer Oberseite (3a) und einer Unterseite (3b),
- ein elektronisches Bauteil (4),
- eine Flachfeder (10),
wobei das elektronische Bauteil (4) auf der Oberseite (4a) angeordnet ist und der Kühlkörper (2) auf dem elektronischen Bauteil (4) aufliegt,
**dadurch gekennzeichnet, dass** die Flachfeder (10) an der Unterseite (3b) derart angeordnet ist, dass sie mit einem ersten Haltemittel (11a) und einem zweitem Haltemittel (12a) durch eine erste Ausnehmung (31) und eine zweite Ausnehmung (32) in der Trägervorrichtung (3) greift, wobei der Kühlkörper (2) ein erstes Verrastmittel (21) und ein zweites Verrastmittel (22) aufweist, in welche die Haltemittel (11a,12a) verrasten, wobei die Flachfeder (10) derart vorgeprägt ist, dass diese im gespannten Zustand eine Anpresskraft (F) zentrisch unter dem elektronischen Bauteil in die Trägervorrichtung (3) einleitet.

2. Kühlvorrichtung (1) nach Anspruch 1, wobei die Flachfeder (10) einen ersten Schenkel (11), an welchem das erste Haltemittel (11a) angeordnet ist, und einen zweiten Schenkel (12), an welchem das zweite Haltemittel (12a) angeordnet ist, aufweist.

3. Kühlvorrichtung (1) nach Anspruch 1 oder 2, wobei auf einem Federkörper (10a) der Flachfeder (10) zwischen dem ersten Haltemittel (11a) und dem zweiten Haltemittel (12a) eine punktuelle Erhebung zur Einleitung der Anpresskraft (F) angeordnet ist.

4. Kühlvorrichtung (1) nach Anspruch 3, wobei die punktuelle Erhebung als eine Sicke (14) ausgestaltet ist.

5. Kühlvorrichtung (1) nach Anspruch 3, wobei die punktuelle Erhebung als ein Niet (15) ausgestaltet ist.

6. Kühlvorrichtung (1) nach Anspruch 3,4 und 5, wobei der Niet (15) in der Sicke (14) angeordnet ist.

7. Kühlvorrichtung (1) nach einem der Ansprüche 2 bis 6, wobei die Flachfeder (10) einen dritten Schenkel (13), an welchem ein drittes Haltemittel (13a) angeordnet ist, aufweist.

8. Kühlvorrichtung (1) nach Anspruch 7, wobei die Flachfeder (10) Y-förmig ausgestaltet ist.

9. Kühlvorrichtung (1) nach einem der Ansprüche 1 bis 8, wobei zwischen dem elektronischen Bauteil (4) und dem Kühlkörper (2) ein Wärmeleitmittel (16) angeordnet ist.

10. Kühlvorrichtung (1) nach einem der Ansprüche 1 bis 9, wobei in der Umgebung um das elektronischen Bauteil (4) ein oder mehrere Abstandshalter derart angeordnet sind, dass der Kühlkörper (2) eine Kippgrenze nicht überschreiten kann.
